# EUROPÄISCHE PATENTSCHRIFT

(11) **EP 1 566 464 B1**
(45) Veröffentlichungstag und Bekanntmachung des Hinweises auf die Patenterteilung: **13.04.2011**
(21) Anmeldenummer: 04003928.1
(22) Anmeldetag: 20.02.2004
(51) Int. Cl.: C23C 16/448, G01F 11/28, G05D 9/04

(54) **Vorrichtung und Verfahren zum Nachfüllen eines Blasenverdampfers**
Apparatus and method for replenishing a bubbling device
Dispositif et procédé de remplissage d'un vaporisateur de liquide pneumatique

(43) Veröffentlichungstag der Anmeldung: 24.08.2005
(73) Patentinhaber: CS CLEAN SYSTEMS AG, 85732 Ismaning (DE)
(72) Erfinder: Scholz, Christoph, Dr., 83666 Waakirchen (DE)
(74) Vertreter: Karakatsanis, Georgios

(56) Entgegenhaltungen:
- EP-A- 0 147 663
- WO-A-86/01232
- WO-A-92/05406
- PATENT ABSTRACTS OF JAPAN Bd. 0122, Nr. 09 (C-504), 15. Juni 1988 (1988-06-15) & JP 63 008232 A (SUMITOMO ELECTRIC IND LTD), 14. Januar 1988 (1988-01-14)

## Beschreibung

Die Erfindung bezieht sich auf eine Vorrichtung und ein Verfahren zum Nachfüllen eines Blasenverdampfers (bubbler), mit dem ein Trägergas in eine flüssige Substanz geleitet wird, um sie zu verdampfen und einem Verbraucher zuzuführen, gemäß dem Oberbegriff des Anspruchs 1 bzw. 7.

Eine derartige Vorrichtung bzw. ein derartiges Verfahren ist bereits bekannt, zum Beispiel aus dem Dokument WO 86/01232 A. Ein solcher Verbraucher ist beispielsweise ein Reaktor zur chemischen Dampfabscheidung (CVD). Mit solchen CVD-Reaktoren werden integrierte Mikroschaltungen und dergleichen elektronische Bauelemente hergestellt. Um den ständig steigenden Ansprüchen solcher Elemente zu genügen, müssen für die chemische Dampfabscheidung Substanzen höchster Reinheit eingesetzt werden. Es handelt sich dabei meist um organische Metall- und Halbmetallverbindungen, die in flüssiger Form vorliegen.

Neben höchster Reinheit ist von Bedeutung, dass eine bestimmte Zusammensetzung des Gasgemisches in dem CVD-Reaktor und damit die Menge der jeweiligen dem CVD-Reaktor zugeführten Substanz exakt eingehalten wird. Um eine Änderung der Zusammensetzung durch Kondensieren der verdampften Substanz in der Leitung zum CVD-Reaktor zu verhindern, muss der Blasenverdampfer möglichst nahe am Reaktor angeordnet werden. Die Blasenverdampfer weisen deshalb ein kleines Volumen auf, so dass sie häufig nachgefüllt werden müssen. Dazu wird bei der bekannten Vorrichtung die flüssige Substanz aus dem Vorratsbehälter mit einem Inertgas in den Blasenverdampfer gedrückt.

Die Menge der jeweiligen Substanz, die dem CVD-Reaktor zugeführt wird, hängt von dem Weg ab, den die Trägergasblasen in der flüssigen Substanz zurücklegen, wenn sie in der flüssigen Substanz aufsteigen. Durch Verdampfen der flüssigen Substanz im Blasenverdampfer wird dieser Weg mit der Zeit kürzer und damit die Menge der verdampften Substanz im Trägergas geringer. Um die dadurch verursachten Konzentrationsschwankungen möglichst gering zu halten, sind bei der bekannten Vorrichtung ein Füllstandsensor für den Minimalfüllstand und ein Füllstandsensor für den Maximalfüllstand vorgesehen.

Füllstandsensoren sind jedoch von Haus aus eher ungenau und nicht sehr zuverlässig. Der Einsatz von zwei Füllstandsensoren ist daher mit erheblichen Problemen verbunden. Hinzu kommt, dass die verwendeten flüssigen Substanzen häufig pyrophor sind, so dass das Auslaufen einer solchen Substanz aus dem Blasenverdampfer wegen einer fehlerhaften Funktion des Füllstandsensors für den Maximalfüllstand eine erhebliche Gefahr darstellt.

Aufgabe der Erfindung ist es, ein einfaches Nachfüllsystem bereitzustellen, mit dem der Minimal- und Maximalfüllstand in dem Blasenverdampfer genau und zuverlässig eingehalten wird.

Dies wird erfindungsgemäß mit der im Anspruch 1 gekennzeichneten Vorrichtung erreicht. In den Ansprüchen 2 bis 6 sind vorteilhafte Ausgestaltungen der erfindungsgemäßen Vorrichtung wiedergegeben.

Im Anspruch 7 ist ein bevorzugtes Verfahren zum Nachfüllen des erfindungsgemäßen Blasenverdampfers angegeben, welches durch die Merkmale der Ansprüche 8 und 9 weiter ausgebildet wird.

Erfindungsgemäß wird dem Blasenverdampfer beim Nachfüllen eine genau definierte Menge der flüssigen Substanz zugeführt. Die Genauigkeit wird dabei allein durch die Druckmessung bestimmt. Da handelsübliche Druckaufnehmer mit einer Genauigkeit zur Verfügung stehen, die im Promille-Bereich liegt, kann erfindungsgemäß der Füllstand in dem Blasenverdampfer genau eingestellt werden.

Als Trägergas zum Verdampfen der flüssigen Substanz in dem Blasenverdampfer wird ein Inertgas verwendet, beispielsweise ein Edelgas wie Argon. Das Inertgas, das dem Vorratsbehälter, dem Zwischenbehälter und der Verbindungsleitung zwischen Vorratsbehälter und Blasenverdampfer über die daran jeweils angeschlossene Inertgasleitung zugeführt wird, kann ebenfalls ein Edelgas wie Argon sein.

Der Füllstandsensor, der erfindungsgemäß den Minimalfüllstand in dem Blasenverdampfer erfasst, kann beispielsweise ein Thermofühler, ein Schwimmer, ein Ultraschall- oder Radarsensor oder dergleichen sein.

An den Blasenverdampfer sind die Verbindungsleitung und die Versorgungsleitung zu dem Verbraucher angeschlossen. Die Trägergasleitung taucht mit einem Tauchrohr in die flüssige Substanz in dem Blasenverdampfer ein, um mit den in der flüssigen Substanz nach oben aufsteigenden Trägergasblasen die verdampfte flüssige Substanz aufzunehmen.

Um einen stabilen Fluss des Trägergases mit der verdampften Substanz zu dem Verbraucher von Prozessbeginn an zu erhalten, ist ferner eine Gasaustrittsleitung mit einem Ventil an der Versorgungsleitung vorgesehen, durch das das Trägergas mit der verdampften Substanz zunächst geleitet wird, bevor die Versorgungsleitung zu dem Verbraucher geöffnet wird.

Während der Zwischenbehälter vorzugsweise nahe dem zentralen Vorratsbehälter angeordnet ist, ist der Blasenverdampfer im allgemeinen nahe beim Verbraucher angeordnet. Dabei sind Vorratsbehälter und Zwischenbehälter meist tiefer angeordnet als der Blasenverdampfer und der Verbraucher. In einem Gebäude kann die Verbindungsleitung als oft mehrere Meter lange Steigleitung von dem Vorrats- und Zwischenbehälter zu dem Blasenverdampfer ausgebildet sein.

Wenn mehrere Blasenverdampfer durch einen zentralen Vorratsbehälter über den Zwischenbehälter befüllt werden sollen, bildet der Abschnitt der Verbindungsleitung von dem Tauchrohr in dem Vorratsbehälter bis zu der Inertgasleitung den Hauptabschnitt der Verbindungsleitung, von dem jeweils Einzelleitungen als Steigleitungen zu den jeweiligen Blasenverdampfern führen. Zwischen der Inertgasleitung und dem jeweiligen Blasenverdampfer ist dann in jeder Einzelleitung ein Ventil vorgesehen. Mit dem Druckregler in der Inertgasleitung kann dann individuell der Druck in den Steigleitungen zu den beispielsweise auf verschiedenen Stockwerken angeordneten Blasenverdampfern eingestellt werden.

Wenn bei der erfindungsgemäßen Vorrichtung durch den Füllstandsensor der Mindestfüllstand festgestellt worden ist, steuert der Füllstandsensor die Steuereinrichtung an, die dann durch Ventilbetätigung folgende Schritte durchführt:
(1) Das Ventil in der Trägergasleitung und das Ventil in der Versorgungsleitung werden geschlossen und der Blasenverdampfer wird, z.B. über die Gasaustrittsleitung oder über die Inertgasleitung, die an die Verbindungsleitung angeschlossen ist, bis zum Dampfdruck der flüssigen Substanz 3 evakuiert. In dem leeren Zwischenbehälter wird über die an ihn angeschlossene Inertgasleitung ein vorgegebener Druck (P1) eingestellt.
(2) Über die an den Vorratsbehälter angeschlossene Inertgasleitung wird in dem Vorratsbehälter ein vorgegebener Druck (P2) eingestellt, welcher größer ist als der beim Schritt (1) eingestellte Druck (P1) in dem Zwischenbehälter.
(3) Der Vorratsbehälter wird mit dem Zwischenbehälter verbunden, um eine Menge der flüssigen Substanz in den Zwischenbehälter zu füllen, die der Druckdifferenz (ΔP) zwischen dem Druck (P2) in dem Vorratsbehälter und dem Druck (P1) in dem Zwischenbehälter x dem Volumen des Zwischenbehälters nach dem Boyle-Mariotteschen Gesetz P x V = konst. entspricht.
(4) Die Verbindung zwischen dem Vorratsbehälter und dem Zwischenbehälter wird getrennt. Im Zwischenbehälter ist damit eine genau definierte Menge der flüssigen Substanz enthalten.
(5) Über die an die Verbindungsleitung angeschlossene Inertgasleitung wird in dem Abschnitt der Verbindungsleitung zwischen der Anschlussleitung von dem Zwischenbehälter und dem Blasenverdampfer sowie in dem Blasenverdampfer ein Druck (P3) eingestellt, der kleiner ist als der beim Schritt (3) in dem Zwischenbehälter erreichte Druck.
(6) Der Zwischenbehälter und der Blasenverdampfer werden miteinander verbunden, um eine Menge der flüssigen Substanz in den Blasenverdampfer zu füllen, die der Druckdifferenz zwischen dem Druck (P2) in dem Zwischenbehälter und dem Druck (P3) in dem Blasenverdampfer und dem Verbindungsleitungsabschnitt zwischen der Inertgasleitung und dem Blasenverdampfer minus dem hydrostatischen Druck durch den Höhenunterschied zwischen dem Zwischenbehälter und dem Blasenverdampfer entspricht. Damit ist die im Zwischenbehälter genau vorgegebene Menge von dem Zwischenbehälter in den Blasenverdampfer übergeführt worden.

Um die Verbindungsleitung zu entleeren, werden vorzugsweise anschließend noch folgende Schritte durchgeführt:
(7) Der Vorratsbehälter wird evakuiert, und
(8) die flüssige Substanz in der Verbindungsleitung wird in den evakuierten Vorratsbehälter zurückgesaugt.

Nach dem Füllen des Blasenverdampfers wird in die flüssige Substanz im Blasenverdampfer Trägergas eingeleitet, wobei das Trägergas mit der darin enthaltenen verdampften flüssigen Substanz zunächst über die Gasaustrittsleitung austritt, bis ein stabiler Fluss des Trägergases mit der verdampften Substanz erreicht ist, worauf die Versorgungsleitung zu dem Verbraucher geöffnet wird.

Durch die erfindungsgemäße Einrichtung wird die Sicherheit wesentlich erhöht. So wird der Füllstandssensor für den Maximalfüllstand durch Druckregler oder -aufnehmer ersetzt, die wesentlich zuverlässiger, präziser und im übrigen auch kostengünstiger sind. Während Füllstandssensoren "single-point-of-failure"-Einrichtungen darstellen, liegt, da bei den Schritten 1. bis 6. stets zwei Druckaufnehmer beteiligt sind, erfindungsgemäß Redundanz vor. Zudem ist die Verbindungsleitung nur während des Nachfüllens des Blasenverdampfers gefüllt, sonst, also während des größten Teils der Zeit aber produktfrei.

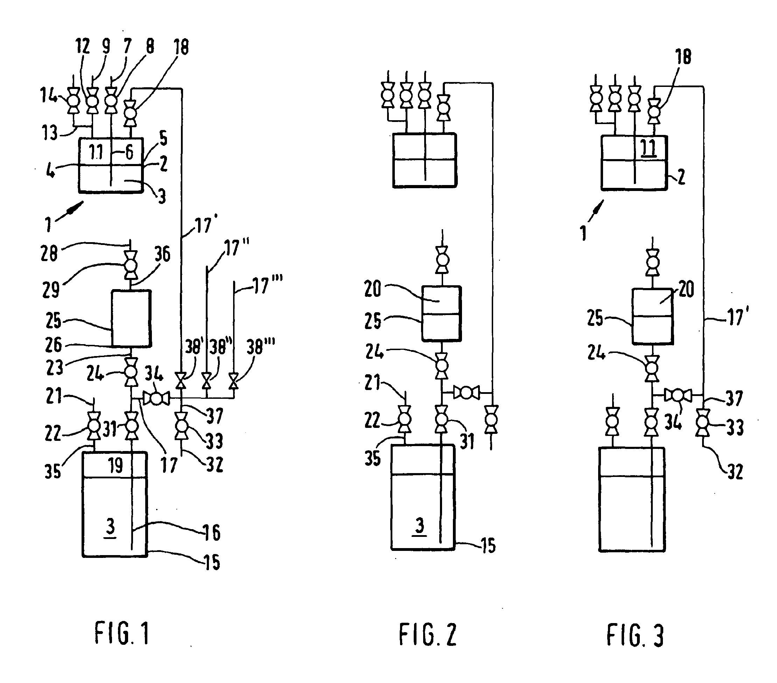

Nachstehend ist die Erfindung anhand der Zeichnung beispielhaft näher erläutert. Darin zeigen jeweils schematisch die Figuren 1 bis 6 eine Ausführungsform der erfindungsgemäßen Vorrichtung mit den einzelnen Schritten zum Nachfüllen des Blasenverdampfers.

Gemäß Figur 1 weist ein Blasenverdampfer 1 einen Behälter 2 auf, der mit einer flüssigen Substanz 3 gefüllt ist, und zwar gemäß Figur 1 mit dem Minimalfüllstand 4, der von einem Füllstandsensor 5 erfasst wird.

In die flüssige Substanz 3 taucht ein Tauchrohr 6 ein, durch das mit einer Trägergasleitung 7 mit einem Ventil 8 ein Trägergas in die flüssige Substanz 3 geleitet wird, um die flüssige Substanz 3 zu verdampfen.

Die verdampfte flüssige Substanz 3 wird über eine Versorgungsleitung 9 einem nicht dargestellten Verbraucher, z.B. einem CVD-Reaktor, zugeführt. Die an den Gasraum 11 des Blasenverdampfers 1 angeschlossene Versorgungsleitung 9 ist mit einem Ventil 12 versehen. Zwischen dem Gasraum 11 und dem Ventil 12 ist an die Versorgungsleitung 9 eine Gasaustrittsleitung 13 mit einem Ventil 14 angeschlossen.

Die flüssige Substanz 3 zum Nachfüllen des Blasenverdampfers 1 wird in einem Vorratsbehälter 15 aufbewahrt. In die flüssige Substanz 3 in dem Vorratsbehälter 15 ragt ein Tauchrohr 16, das mit einer Verbindungsleitung 17 mit dem Gasraum 11 des Blasenverdampfers 1 verbunden ist, wobei an dem dem Blasenverdampfer 1 zugewandten Ende der Verbindungsleitung 17 ein Einfüllventil 18 vorgesehen ist.

An den Gasraum 19 des Vorratsbehälters 15 ist eine Inertgasleitung 21 mit einem Ventil 22 angeschlossen. Über die Inertgasleitung 21 kann der Vorratsbehälter 15 auch evakuiert werden.

An den dem Vorratsbehälter 15 zugewandten Endbereich der Verbindungsleitung 17 ist an die Verbindungsleitung 17 über eine Anschlussleitung 23 mit einem Ventil 24 ein Zwischenbehälter 25 angeschlossen, der ein wesentlich kleineres Volumen aufweist als der Vorratsbehälter 15. Die Anschlussleitung 23 ist am Boden 26 des Zwischenbehälters 25 angeschlossen. An den oberen Bereich des Zwischenbehälters 25 ist eine Inertgasleitung 28 mit einem Ventil 29 angeschlossen.

Zwischen der Anschlussleitung 23 und dem Tauchrohr 16 ist in der Verbindungsleitung 17 ein weiteres Ventil 31 vorgesehen. Ferner ist zwischen der Anschlussleitung 23 und dem Einfüllventil 18 an die Verbindungsleitung 17 eine Inertgasleitung 32 mit einem Ventil 33 angeschlossen, und zwar ebenfalls an den dem Vorratsbehälter 5 zugewandten Endbereich der Verbindungsleitung 17. Ein weiteres Ventil 34 ist in der Verbindungsleitung 17 zwischen der Anschlussleitung 23 und der Inertgasleitung 32 vorgesehen.

In der an den Gasraum 19 des Vorratsbehälters 15 angeschlossenen Inertgasleitung, in der an den Zwischenbehälter 25 angeschlossenen Inertgasleitung 28 und in der an die Verbindungsleitung 17 angeschlossenen Inertgasleitung 32 ist jeweils ein Druckregler 35, 36 bzw. 37 vorgesehen.

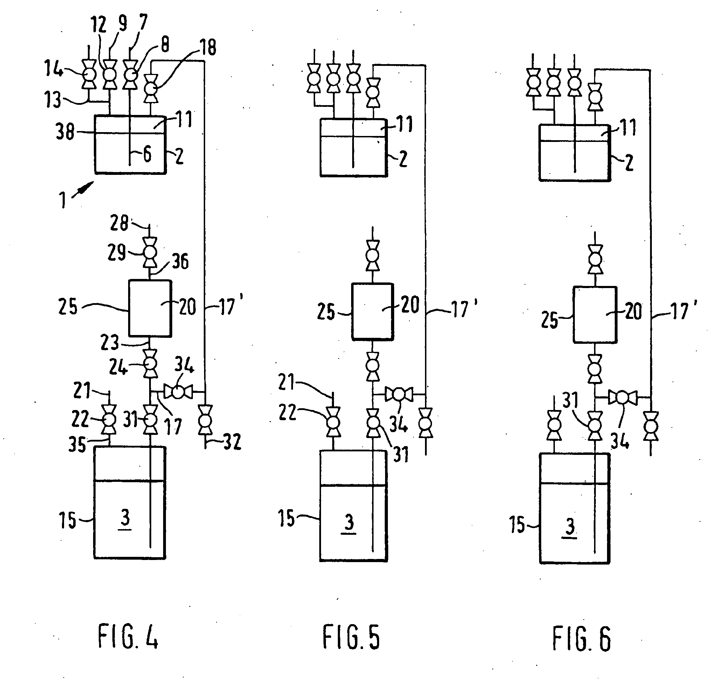

Durch den Anschluss der Anschlussleitung 23 an den Boden 26 des Zwischenbehälters 25 wird, wie aus Figur 3 und 4 hervorgeht und nachstehend noch näher beschrieben wird, die flüssige Substanz aus dem Zwischenbehälter 25 vollständig entleert, wenn der Zwischenbehälter 25 mit einem hinreichend hohen Inertgasdruck beaufschlagt wird.

Wie an die an den Gasraum 19 des Vorratsbehälters 15 angeschlossene Inertgasleitung 21 kann auch an die an die Verbindungsleitung 17 angeschlossene Inertgasleitung 32 ein Vakuum angeschlossen werden. Ferner kann an die Gasaustrittsleitung 13 ein Vakuum angelegt werden, um die Verbindungsleitung und den Behälter 2 des Blasenverdampfers 1 zu evakuieren.

Der Abschnitt der Verbindungsleitung 17 zwischen der Inertgasleitung 32 und dem Einfüllventil 18 ist als Steigleitung 17' ausgebildet. Falls aus dem Vorratsbehälter 15 mit dem Zwischenbehälter 25 mehrere Blasenverdampfer 1 für mehrere Verbraucher nachgefüllt werden sollen, bildet der Abschnitt der Verbindungsleitung 17 von dem Tauchrohr 16 bis zu der Inertgasleitung 32 den Hauptabschnitt, von dem, wie in Figur 1 schematisch dargestellt, dann Einzelleitungen 17', 17'', 17''' zu dem jeweiligen Blasenverdampfer 1 führen. Dabei ist in jeder Einzelleitung 17', 17'', 17''' ein Ventil 38', 38'', 38''' zwischen der Inertgasleitung 32 und dem jeweiligen Blasenverdampfer 1 an dem der Inertgasleitung 32 zugewandten Endbereich der Einzelleitung 17', 17'', 17''' vorgesehen.

Folgendes Beispiel dient zusammen mit den Figuren 1 bis 6 der weiteren Erläuterung der Erfindung, wobei evakuierte Räume in den Behältern weiß, mit Gas gefüllte grau und mit Flüssigkeit gefüllte dunkel dargestellt sind. Ferner wird in diesem Beispiel die Vorrichtung mit nur einer Steigleitung 17' beschrieben also ohne Ventil 38'.

Der Behälter 2 weist ein Volumen von z.B. 1 000 cm³ auf. Wenn der Füllstand der flüssigen Substanz 3 in dem Blasenverdampfer 1 gemäß Figur 1 auf den Mindestfüllstand 4 von z.B. 500 cm³ abgesunken ist, wird durch den Füllstandsensor 5 die nicht dargestellte Steuereinrichtung angesteuert, die zum Nachfüllen der flüssigen Substanz 3 in den Blasenverdampfer 1 die Ventile 8, 12, 14, 18, 22, 24, 29, 31, 33 und 34 wie folgt betätigt:
1. Schritt (Figur 1)
   Die Ventile 8, 12, 22, 24, 29, 31, 33, 34 sind geschlossen und die Ventile 14 und 18 geöffnet, um den Behälter 2 des Blasenverdampfers 1 über die Gasaustrittsleitung 13 und den Abschnitt 17' der Verbindungsleitung 17 zwischen der Inertgasleitung 32 und dem Behälter 2 zu evakuieren. Der Zwischenbehälter 25, der ein Volumen von z.B. 1 000 cm³ aufweist, ist leer, d.h. er enthält keine flüssige Substanz 3. Das Ventil 29 wird geöffnet und der Zwischenbehälter 25 mit Inertgas gefüllt, bis der Druckregler 36 einen vorgegebenen Druck P1 von z.B. 200 000 Pa in dem Zwischenbehälter 25 anzeigt. Das Ventil 29 wird geschlossen.
2. Schritt (Figur 2)
   Das Ventil 22 wird geöffnet und über die Inertgasleitung 21 dem evakuierten Gasraum 19 in dem Vorratsbehälter 15 Inertgas zugeführt, bis der Druckregler 35 einen vorgegebenen Druck P2 von z.B. 400 000 Pa in dem Vorratsbehälter 15 anzeigt.
3. Schritt (Figur 2)
   Die Ventile 24 und 31 werden geöffnet, um den Vorratsbehälter 15 mit dem Zwischenbehälter 25 zu verbinden. Damit strömt flüssige Substanz 3 von dem Vorratsbehälter 15 in den Zwischenbehälter 25, bis der Druck im Gasraum 20 des Zwischenbehälters P2 also 400 000 Pa beträgt. Entsprechend der Gleichung P x V = konst. ist damit der Zwischenbehälter 25 mit 500 cm³ der flüssigen Substanz 3 gefüllt.
4. Schritt (Figur 2)
   Die Ventile 24 und 31 werden geschlossen, und damit die Verbindung zwischen dem Vorratsbehälter 15 und dem Zwischenbehälter 25 getrennt. Der Druck im Gasraum 19 des Vorratsbehälters 15 wird über das Ventil 22 reduziert, das Ventil 22 dann geschlossen. Damit ist die Phase abgeschlossen, mit der exakt 500 ml der flüssigen Substanz 3 von dem Vorratsbehälter 15 in den Zwischenbehälter 25 übergeführt worden sind.
5. Schritt (Figur 3)
   Die Ventile 18 und 33 werden geöffnet, um den Abschnitt 17' der Verbindungsleitung 17 zwischen der Inertgasleitung 32 und dem Blasenverdampfer 1 sowie den Behälter 2 des Blasenverdampfers 1 mit Inertgas zu füllen, bis der Druckregler 37 einen vorgegebenen Druck P3 von z.B. 50 000 Pa anzeigt. Das Ventil 33 wird geschlossen.
6. Schritt (Figur 4)
   Das Volumen des Gasraums 20 im Zwischenbehälter 25 beträgt 500 cm³ bei einem Druck von 400 000 Pa.
   Das Volumen des Gasraums in dem Steigleitungsabschnitt 17' der Verbindungsleitung 17 zwischen der Inertgasleitung 32 und dem Blasenverdampfer 1 beträgt 250 cm³ und das Volumen des Gasraums 11 des Behälters 2 des Blasenverdampfers 1 500 cm³, d.h. das Gesamtvolumen der Steigleitung 17' und des Gasraums 11 beträgt 750 cm³ bei einem Druck von 50 000 Pa.
   Die Ventile 24 und 34 werden geöffnet. Damit werden 500 cm³ flüssige Substanz 3 in die Steigleitung 17' und in den Blasenverdampfer 1 übergeführt, und zwar 250 cm³ in die Steigleitung 17' und 250 cm³ in den Blasenverdampfer 1. Damit ist der Maximalfüllstand 38 im Blasenverdampfer 1 erreicht. Das Druckgleichgewicht wird erreicht, wenn in dem entleerten Zwischenbehälter 25 mit einem Gasraum 20 von 1 000 cm³ ein Druck von 200 000 Pa herrscht und in dem Gasraum 11 des Behälters 2 ein Druck von 200 000 Pa minus dem hydrostatischen Druck der Steigleitung 17', welche von der Höhe der Steigleitung 17' und der Dichte der flüssigen Substanz 3 abhängt, wobei der hydrostatische Druck z.B. bei Trimethylaluminium als flüssige Substanz 3 und einer Höhe der Steigleitung 17' von 7 m 50 000 Pa beträgt.
7. Schritt (Figur 5)
   Das Ventil 22 wird geöffnet und der Vorratsbehälter 15 über die Inertgasleitung 21 bis zum Dampfdruck der flüssigen Substanz 3 evakuiert, der beispielsweise bei Trimethylaluminium 1,036 Pa beträgt. Das Ventil 22 wird geschlossen.
8. Schritt (Figur 6)
   Die Ventile 31 und 34 werden geöffnet, wodurch die in der Steigleitung 17' enthaltene flüssige Substanz (250 cm³) in den Vorratsbehälter 15 zurückgesaugt wird. Die Ventile 31 und 34 werden geschlossen.

Während die Schritte 1. bis 4. der Überführung der flüssigen Substanz 3 von dem Vorratsbehälter 15 in den Zwischenbehälter 25 dienen und die Schritte 5. und 6. dem Überführen der flüssigen Substanz 3 aus dem Zwischenbehälter 25 in den Blasenverdampfer 1, dienen die Schritte 7. und 8. der Entleerung der Verbindungsleitung 17 nach Beendigung des Nachfüllvorgangs.

Mit der erfindungsgemäßen Vorrichtung müssen also keine Messwerte erfasst werden. Auch muss kein Prozesssignal beachtet werden, um den Nachfüllzyklus zu beenden.

Auch ist mit der erfindungsgemäßen Vorrichtung die Zeitdauer eines Nachfüllzyklus kurz, so beträgt sie nach dem vorstehend geschilderten Beispiel lediglich etwa 1 min.

## Patentansprüche

1. Vorrichtung zum Nachfüllen wenigstens eines Blasenverdampfers (1) mit einem Behälter (2) mit einer flüssigen Substanz (3), in die über eine Trägergasleitung (7) ein Trägergas geleitet wird, um die flüssige Substanz (3) zu verdampfen und sie über eine Versorgungsleitung (9) einem Verbraucher zuzuführen,
mit einem mit der flüssigen Substanz (3) gefüllten Vorratsbehälter (15), in den ein Tauchrohr (16) ragt, das über eine Verbindungsleitung (17) mit dem Blasenverdampfer (1) verbunden ist,
einer an den Gasraum (19) des Vorratsbehälters (15) angeschlossenen Inertgasleitung (21) mit einem Ventil (22),
einem Einfüllventil (18) in der Verbindungsleitung (17) zum Einfüllen der flüssigen Substanz (3) in den Blasenverdampfer (1),
einem Ventil (12) in der Versorgungsleitung (9), einem Ventil (8) in der Trägergasleitung (7),
einem Füllstandsensor (5) in dem Blasenverdampfer (1), und
einer Steuereinrichtung zur Bestätigung der Ventile, welche von dem Füllstandsensor (5) bei Erreichen eines Mindestfüllstands (4) zum Nachfüllen des Blasenverdampfers (1) angesteuert wird,
**gekennzeichnet durch**
einen Zwischenbehälter (25) mit einem kleineren Volumen als der Vorratsbehälter (15),
eine an den Zwischenbehälter (25) angeschlossene Inertgasleitung (28) mit einem Ventil (29),
eine Anschlussleitung (23) mit einem Ventil (24) von dem Zwischenbehälter (25) zu der Verbindungsleitung (17),
ein Ventil (31) in der Verbindungsleitung (17) zwischen dem Tauchrohr (16) und der Anschlussleitung (23),
eine zwischen der Anschlussleitung (23) und dem Einfüllventil (18) an die Verbindungsleitung (17) angeschlossene Inertgasleitung (32) mit einem Ventil (33), und
ein Ventil (34) in der Verbindungsleitung (17) zwischen der Anschlussleitung (23) und der an die Verbindungsleitung (17) angeschlossenen Inertgasleitung (32), wobei jeweils ein Druckregler (35, 36, 37) in der an den Vorratsbehälter (15) angeschlossenen Inertgasleitung (21), in der an den Zwischenbehälter (25) angeschlossenen Inertgasleitung (28) und in der an die Verbindungsleitung (17) angeschlossenen Inertgasleitung (32) vorgesehen ist, und die an den Vorratsbehälter (15) angeschlossene Inertgasleitung (21) und/oder die an die Verbindungsleitung (17) angeschlossene Inertgasleitung (32) und/oder die an den Blasenverdampfer (1) angeschlossene Gasaustrittsleitung (13) an ein Vakuum anschließbar ist.

2. Vorrichtung nach Anspruch 1, **dadurch gekennzeichnet, dass** die Anschlussleitung (23) an dem Zwischenbehälter (25) so angebracht ist, dass der Zwischenbehälter (25) bei Beaufschlagung mit Inertgas über die Inertgasleitung (28) vollständig entleert wird.

3. Vorrichtung nach einem der vorstehenden Ansprüche, **dadurch gekennzeichnet, dass** an dem Behälter (2) des Blasenverdampfers (1) eine Gasaustrittsleitung (13) mit einem Ventil (14) vorgesehen ist.

4. Vorrichtung nach einem der vorstehenden Ansprüche, **dadurch gekennzeichnet, dass** mehrere Blasenverdampfer für mehrere Verbraucher vorgesehen sind und der Abschnitt der Verbindungsleitung (17) von dem Tauchrohr (16) bis zu der Inertgasleitung (32) den Hauptabschnitt der Verbindungsleitung (17) bildet, von dem je eine Einzelleitung (17', 17", 17"') zu dem jeweiligen Blasenverdampfer (1) führt.

5. Vorrichtung nach Anspruch 1 oder 4, **dadurch gekennzeichnet, dass** der Abschnitt (17') der Verbindungsleitung (17) oder die Einzelleitungen (17', 17", 17"') zwischen der Inertgasleitung (32) und dem Blasenverdampfer (1) durch eine Steigleitung gebildet wird bzw. werden.

6. Vorrichtung nach Anspruch 4 oder 5, **dadurch gekennzeichnet, dass** jede Einzelleitung (17', 17", 17"') ein Ventil (35', 35", 35"') zwischen der Inertgasleitung (32) und dem Einfüllventil (18) am jeweiligen Blasenverdampfer (1) aufweist.

7. Verfahren zum Nachfüllen wenigstens eines Blasenverdampfers (1) mit einer Vorrichtung nach einem der vorstehenden Ansprüche, **dadurch gekennzeichnet, dass** nach Erreichen den Mindestfüllstands (4) der Füllstandsensor (5) die Steuereinrichtung ansteuert, um folgende Schritte durchzuführen:
(1.) nach dem Schließen des Ventils (8) in der Trägergasleitung (7) und des Ventils (12) in der Versorgungsleitung (9) sowie Evakuieren des Blasenverdampfers (1) wird in dem leeren Zwischenbehälter (25) über die an ihn angeschlossene Inertgasleitung (28) ein vorgegebener Druck (P1) eingestellt,
(2.) über die an ihn angeschlossene Inertgasleitung (21) wird in dem Vorratsbehälter (15) ein vorgegebener Druck (P2) eingestellt, der größer ist als der beim Schritt (1.) eingestellte Druck (P1) in dem Zwischenbehälter (25),
(3.) der Vorratsbehälter (15) wird mit dem Zwischenbehälter (25) verbunden, um eine der Druckdifferenz zwischen dem Druck (P2) im Vorratsbehälter (15) und dem Druck (P1) im Zwischenbehälter (25) entsprechende Menge der flüssigen Substanz (3) in den Zwischenbehälter (25) zu überführen,
(4.) die Verbindung zwischen dem Vorratsbehälter (15) und dem Zwischenbehälter (25) wird getrennt,
(5.) über die an die Verbindungsleitung (17) angeschlossene Inertgasleitung (32) wird in dem Abschnitt (17') der Verbindungsleitung (17) zwischen der Anschlussleitung (23) von dem Zwischenbehälter (25) und dem Blasenverdampfer (1) sowie in dem Blasenverdampfer (1) ein Druck (P3) eingestellt, der kleiner ist als der beim Schritt (3.) in dem Zwischenbehälter (25) erreichte Druck,
(6.) der Zwischenbehälter (25) und der Blasenverdampfer (1) werden miteinander verbunden, um die in dem Zwischenbehälter (25) enthaltene flüssige Substanz (3) in den Abschnitt (17') der Verbindungsleitung (17) zwischen der Anschlussleitung (23) und dem Blasenverdampfer (1) sowie in den Blasenverdampfer (1) überzuführen.

8. Verfahren nach Anspruch 7, **dadurch gekennzeichnet, dass** im Anschluss an den Schritt (6.)
(7.) der Vorratsbehälter (15) evakuiert und
(8.) die flüssige Substanz (8) in der Verbindungsleitung (17) in den evakuierten Vorratsbehälter (15) zurückgesaugt wird.

9. Verfahren nach Anspruch 7 oder 8, **dadurch gekennzeichnet, dass** bei einem tiefer als dem Blasenverdampfer (1) angeordneten Zwischenbehälter (25) beim Schritt (5.) das Überführen der flüssigen Substanz (3) aus dem Zwischenbehälter (25) in die Verbindungsleitung (17) und den Blasenverdampfer (1) abgeschlossen ist, wenn der Druck in dem Blasenverdampfer (1) dem Druck (P2) in dem Zwischenbehälter (25) abzüglich des hydrostatischen Drucks durch den Höhenunterschied zwischen dem Blasenverdampfer (1) und dem Zwischenbehälter (25) entspricht.

## Claims

1. Apparatus for replenishing at least one bubbling device (1) comprising a container (2) holding a liquid substance (3) into which a carrier gas is conducted through a carrier gas line (7) in order to evaporate said liquid substance (3) and to supply it to a consumer through a supply line (9), comprising
a reservoir (15) filled with said liquid substance (3) and having a dip tube (16) extending thereinto which is coupled to the bubbling device (1) through a connecting line (17),
an inert gas line (21) coupled to the gas space (19) of the reservoir (15), said inert gas line having a valve (22) therein,
a filling valve (18) in the connecting line (17) for filling liquid substance (3) into the bubbling device (1),
a valve (12) in the supply line (9),
a valve (8) in the carrier gas line (7),
a fill level sensor (5) in the bubbling device (1), and
control means for actuating said valves which are actuated by the fill level sensor (5) to replenish the bubbling device (1) once a minimum fill level (4) has been reached,
**characterized by**
an intermediate container (25) having a volume smaller than the reservoir (15),
an inert gas line (28) coupled to the intermediate container (25) and having a valve (29) therein,
a line (23) coupling the intermediate container (25) to the connecting line (17) and having a valve (24) therein,
a valve (31) in the connecting line (17) between the dip tube (16) and the line (23),
an inert gas line (32) having a valve (33) therein and coupled to the connecting line (17) between the line (23) and the filling valve (18), and
a valve (34) in the connecting line (17) between line (23) and inert gas line (32) coupled to connecting line (17), with pressure regulators (35, 36, 37) in the inert gas line (21) connected to reservoir (15), in the inert gas line (28) connected to intermediate container (25) and in the inert gas line (32) connected to the connecting line (17), respectively, and with the inert gas line (21) connected to the reservoir (15) and/or the inert gas line (32) connected to the connecting line (17) and/or the gas discharge line (13) connected to the bubbling device (1) being adapted to be connected to a vacuum.

2. Apparatus according to claim 1, **characterized in that** the line (23) is attached to the intermediate container (25) in a manner such that the intermediate container (25) is emptied completely through the inert gas line (28) when it has inert gas applied thereto.

3. Apparatus according to any one of the preceding claims, **characterized in that** the container (2) of the bubbling device (1) is provided with a gas discharge line (13) having a valve (14) therein.

4. Apparatus according to any one of the preceding claims, **characterized in that** a plurality of bubbling devices is provided for a plurality of consumers and **in that** the portion of the connecting line (17) extending from the dip tube (16) to the inert gas line (32) forms the main section of the connecting line (17), from which an individual line (17', 17", 17"') runs to each respective bubbling device.

5. Apparatus according to claims 1 or 4, **characterized by** the section (17') of the connecting line (17) or of the individual lines (17', 17", 17"') between the inert gas line (32) and the bubbling device (1) being formed by a riser line.

6. Apparatus according to claims 4 or 5, **characterized by** the individual lines (17', 17" 17"') each having therein a valve (35', 35", 35"') between the inert gas line (32) and the filling valve (18) at the respective bubbling device (1).

7. Method of replenishing at least one bubbling device comprising the apparatus as specified in one of the preceding claims, **characterized in that**, following the minimum fill level (4) being reached, the fill level sensor (5) actuates said control means to perform the following steps:
(1.) Following the closing of the valve (8) in the carrier gas line (7) and of the valve (12) in the supply line (9), as well as the evacuation of the bubbling device (1), a pre-determined pressure (P1) is established in the empty intermediate container (25) through the inert gas line (28) coupled thereto;
(2.) a pre-determined pressure (P2) is established in the reservoir (15) through the inert gas line (21) coupled thereto, said pressure (P2) being higher than the pressure (P1) in the intermediate container (25) set in step (1.);
(3.) the reservoir (15) is connected to the intermediate container (25) so as to transfer to the intermediate container (25) a quantity of said liquid substance (3) which corresponds to the differential between pressure (P2) in the reservoir (15) and pressure (P1) in the intermediate container (25);
(4.) the connection between the reservoir (15) and the intermediate container (25) is opened;
(5.) through the inert gas line (32) coupled to the connecting line (17), a pressure (P3) is established in portion (17') of the latter between the line (23) from the intermediate container (25) and the bubbling device (1), as well as in the bubbling device (1) itself, said pressure (P3) being lower than the pressure obtained in the intermediate container (25) in step (3.1); and
(6.) the intermediate container (25) and the bubbling device (1) are connected to each other so as to transfer the liquid substance (3) in the intermediate container (25) to portion (17') of the connecting line (17) between line (23) and the bubbling device (1) and to the bubbling device (1).

8. Method according to claim 7, **characterized in that**, following step (6.),
(7.) the reservoir (15) is evacuated and
(8.) the liquid substance (8) in connecting line (17) is aspirated back into the reservoir (15).

9. Method according to claims 7 or 8, **characterized in that**, with the intermediate container (25) at a height lower than the bubbling device (1), the transfer of liquid substance (3) from the intermediate container (25) into the connecting line (17) and the bubbling device (1) in step (5.) is terminated once the pressure in the bubbling device (1) corresponds to pressure (P2) in the intermediate container (25), less the hydrostatic pressure caused by the height differential between the bubbling device (1) and the intermediate container (25).

## Revendications

1. Dispositif pour le remplissage d'au moins un vaporisateur à bulles (1) avec une cuve (2) contenant une substance liquide (3), dans laquelle un gaz porteur est amené par une conduite de gaz porteur (7) pour vaporiser la substance liquide (3) et l'amener à un consommateur en passant par une conduite d'alimentation (9),
avec un réservoir (15) rempli de la substance liquide (3) dans lequel dépasse un tube plongeur (16) qui est relié par une conduite de communication (17) au vaporisateur à bulles (1),
une conduite de gaz inerte (21) munie d'une vanne (22) et reliée à l'espace de gaz (19) du réservoir (15),
une vanne de remplissage (18) dans la conduite de communication (17) pour amener la substance liquide (3) dans le vaporisateur à bulles (1),
une vanne (12) dans la conduite d'alimentation (9),
une vanne (8) dans la conduite de gaz porteur (7),
un capteur de niveau de remplissage (5) dans le vaporisateur à bulles (1),
et
une installation de commande pour l'actionnement des vannes, qui est activée par le capteur de niveau de remplissage (5) quand un niveau de remplissage minimum (4) est atteint pour compléter le niveau du vaporisateur à bulles (1),
**caractérisé en ce qu'**il comporte
un réservoir intermédiaire (25) d'un plus petit volume que le réservoir (15),
une conduite de gaz inerte (28) avec une vanne (29), raccordée au réservoir intermédiaire (25),
une conduite de raccordement (23) avec une vanne (24), allant du réservoir intermédiaire (25) à la conduite de communication (17),
une vanne (31) dans la conduite de communication (17) entre le tube plongeur (16) et la conduite de raccordement (23),
une conduite de gaz inerte (32) avec une vanne (33), raccordée entre la conduite de raccordement (23) et la vanne de remplissage (18) sur la conduite de communication (17), et
une vanne (34) dans la conduite de communication (17) entre la conduite de raccordement (23) et la conduite de gaz inerte (32) raccordée à la conduite de communication (17), un régulateur de pression (35, 36, 37) étant prévu respectivement dans la conduite de gaz inerte (21) raccordée au réservoir (15), dans la conduite de gaz inerte (28) raccordée au réservoir intermédiaire (25) et dans la conduite de gaz inerte (32) raccordée à la conduite de communication (17), et la conduite de gaz inerte (21) raccordée au réservoir (15) et/ou la conduite de gaz inerte (32) raccordée à la conduite de communication (17) et/ou la conduite de sortie de gaz (13) raccordée au vaporisateur à bulles (1) pouvant être raccordées à un vide.

2. Dispositif selon la revendication 1, **caractérisé en ce que** la conduite de raccordement (23) est mise en place sur le réservoir intermédiaire (25) de telle manière que le réservoir intermédiaire (25) soit complètement vidé via la conduite de gaz inerte (28) quand il est exposé à du gaz inerte.

3. Dispositif selon l'une des revendications précédentes, **caractérisé en ce qu'**il est prévu sur la cuve (2) du vaporisateur à bulles (1) une conduite de sortie de gaz (13) avec une vanne (14).

4. Dispositif selon l'une des revendications précédentes, **caractérisé en ce que** plusieurs vaporisateurs à bulles sont prévus pour plusieurs consommateurs et la partie de la conduite de communication (17) allant du tuyau plongeur (16) à la conduite de gaz inerte (32) forme le tronçon principal de la conduite de communication (17), à partir duquel une conduite séparée (17', 17", 17"') mène vers chaque vaporisateur à bulles (1).

5. Dispositif selon la revendication 1 ou 4, **caractérisé en ce que** le tronçon (17') de la conduite de communication (17) ou les conduites séparées (17', 17", 17'") entre la conduite de gaz inerte (32) et le vaporisateur à bulles (1) est ou sont formés par une conduite ascendante.

6. Dispositif selon la revendication 4 ou 5, **caractérisé en ce que** chaque conduite séparée (17', 17", 17"') présente une vanne (35', 35", 35"') entre la conduite de gaz inerte (32) et la vanne de remplissage (18) sur le vaporisateur à bulles (1) correspondant.

7. Procédé pour compléter le niveau d'au moins un le vaporisateur à bulles (1) avec un dispositif selon l'une des revendications précédentes, **caractérisé en ce que** lorsque le niveau de remplissage minimal (4) est atteint, le capteur de niveau de remplissage (5) active l'installation de commande pour exécuter les étapes suivantes :
1) après la fermeture de la vanne (8) dans la conduite de gaz porteur (7) et de la vanne (12) dans la conduite d'alimentation (9) et l'évacuation du vaporisateur à bulles (1), une pression prédéterminée (P1) est établie dans le réservoir intermédiaire (25) via la conduite de gaz inerte (28) raccordée à celui-ci ;
2) une pression prédéterminée (P2), supérieure à la pression (P1) établie dans l'étape 1) dans le réservoir intermédiaire (25), est créée dans le réservoir (15) via la conduite de gaz inerte (21) raccordée à celui-ci ;
3) le réservoir (15) est mis en communication avec le réservoir intermédiaire (25) afin de transférer dans le réservoir intermédiaire (25) une quantité de la substance liquide (3) correspondant à la différence de pression entre la pression (P2) dans le réservoir (15) et la pression (P1) dans le réservoir intermédiaire (25) ;
4) la communication entre le réservoir (15) et le réservoir intermédiaire (25) est coupée ;
5) une pression (P3) inférieure à la pression atteinte dans l'étape 3) dans le réservoir intermédiaire (25) est établie dans le tronçon (17') de la conduite de communication (17) situé entre la conduite de raccordement (23) du réservoir intermédiaire (25) et le vaporisateur à bulles (1) et dans le vaporisateur à bulles (1) via la conduite de gaz inerte (32) raccordée à la conduite de communication (17) ;
6) le réservoir intermédiaire (25) et le vaporisateur à bulles (1) sont mis en communication pour faire passer la substance liquide (3) contenue dans le réservoir intermédiaire (25) dans le tronçon (17') de la conduite de communication (17) entre la conduite de raccordement (23) et le vaporisateur à bulles (1) ainsi que dans le vaporisateur à bulles (1).

8. Procédé selon la revendication 7, **caractérisé en ce qu'**après l'étape 6),
7) le vide est fait dans le réservoir (15) et
8) la substance liquide (8) est réaspirée via la conduite de communication (17) dans le réservoir (15) évacué.

9. Procédé selon la revendication 7 ou 8, **caractérisé en ce que** lorsque le réservoir intermédiaire (25) est disposé plus bas que le vaporisateur à bulles (1), dans l'étape 5), le transfert de la substance liquide (3) du réservoir intermédiaire (25) à la conduite de communication (17) et au vaporisateur à bulles (1) est terminé quand la pression dans le vaporisateur à bulles (1) correspond à la pression (P2) dans le réservoir intermédiaire (25) moins la pression hydrostatique résultant de la différence de hauteur entre le vaporisateur à bulles (1) et le réservoir intermédiaire (25).
